# EUROPEAN PATENT SPECIFICATION

(11) **EP 1 889 308 B1**
(45) Date of publication and mention of the grant of the patent: **02.09.2009**
(21) Application number: 06771169.7
(22) Date of filing: 26.05.2006
(51) Int. Cl.: H01L 45/00, G11C 16/02, G11C 13/02

(54) **MEMORY DEVICE WITH SWITCHING GLASS LAYER**
SPEICHERBAUSTEIN MIT UMSCHALTGLASSCHICHT
DISPOSITIF DE MEMOIRE COMPORTANT UNE COUCHE DE VERRE DE COMMUTATION

(30) Priority: 07.06.2005 US 146091
(43) Date of publication of application: 20.02.2008
(73) Proprietor: Micron Technology, Inc., Boise, ID 83707-0006 (US)
(72) Inventor: CAMPBELL, Kristy, A., Boise, ID 83719 (US)
(74) Representative: Tunstall, Christopher Stephen
(86) International application number: PCT/US2006/020242
(87) International publication number: WO 2006/132813

(56) References cited:
- US-A1- 2003 156 452
- US-A1- 2003 209 971
- US-A1- 2004 042 259
- US-A1- 2004 179 390
- US-A1- 2006 011 910
- US-A1- 2006 186 394

## Description

### FIELD OF THE INVENTION

The invention relates to the field of random access memory (RAM) devices formed using a resistance variable material.

### BACKGROUND

Resistance variable memory elements, which include Programmable Conductive Random Access Memory (PCRAM) elements, have been investigated for suitability as semi-volatile and non-volatile random access memory devices. In a typical PCRAM device, the resistance of a chalcogenide glass backbone can be programmed to stable lower conductivity (i.e., higher resistance) and higher conductivity (i.e., lower resistance) states. An unprogrammed PCRAM device is normally in a lower conductivity, higher resistance state.

A conditioning operation forms a conducting channel of a metal-chalcogenide in the PCRAM device, which supports a conductive pathway for altering the conductivity/resistivity state of the device. The conducting channel remains in the glass backbone even after the device is erased. After the conditioning operation, a write operation will program the PCRAM device to a higher conductivity state, in which metal ions accumulate along the conducting channel(s). The PCRAM device may be read by applying a voltage of a lesser magnitude than required to program it; the current or resistance across the memory device is sensed as higher or lower to define the logic "one" and "zero" states. The PCRAM may be erased by applying a reverse voltage (opposite bias) relative to the write voltage, which disrupts the conductive pathway, but typically leaves the conducting channel intact. In this way, such a device can function as a variable resistance memory having at least two conductivity states, which can define two respective logic states, i.e., at least a bit of data.

One exemplary PCRAM device uses a germanium selenide (i.e., GeₓSe₁₀₀₋ₓ) chalcogenide glass as a backbone. The germanium selenide glass has, in the prior art, incorporated silver (Ag) by (photo or thermal) doping or co-deposition. Other exemplary PCRAM devices have done away with such doping or co-deposition by incorporating a metal-chalcogenide material as a layer of silver selenide (e.g., Ag₂Se), silver sulfide (AgS), or tin selenide (SnSe) in combination with a metal layer, proximate a chalcogenide glass layer, which during conditioning of the PCRAM provides material to form a conducting channel and a conductive pathway in the glass backbone.

Extensive research has been conducted to determine suitable materials and stoichiometries thereof for the glass backbone in PCRAM devices. Germanium selenide having a stoichiomety of about Ge₄₀Se₆₀ (i.e., Ge₂Se₃), as opposed to Ge₂₃Se₇₇ or Ge₃₀Se₇₀, for example, has been found to function well for this purpose. A glass backbone of Ge₄₀Se₆₀, with an accompanying metal-chalcogenide (e.g., typically silver selenide) layer, enables a conducting channel to be formed in the glass backbone during conditioning, which can thereafter be programmed to form a conductive pathway. The metal-chalcogenide is incorporated into chalcogenide, glass layer at the conditioning step. Specifically, the conditioning step comprises applying a potential (about 0.20 V) across the memory element structure of the device such that metal-chalcogenide material is incorporated into the chalcogenide glass layer, thereby forming a conducting channel within the chalcogenide glass layer. It is theorized that Ag₂Se is incorporated onto the glass backbone at Ge-Ge sites via new Ge-Se bonds, which allows silver (Ag) migration into and out of the conducting channel during programming. Movement of metal (e.g., typically silver) ions into or out of the conducting channel during subsequent programming and erasing forms or dissolves a conductive pathway along the conducting channel, which causes a detectible conductivity (or resistance) change across the memory device.

It has been determined that Ge₄₀Se₆₀ works well as the glass backbone in a PCRAM device because this stoichiometry makes for a glass that is rigid and incorporates thermodynamically unstable germanium-germanium (Ge-Ge) bonds. The presence of another species, such as silver selenide provided from an accompanying layer, can, in the presence of an applied potential, break the Ge-Ge bonds and bond with the previously homopolar bonded Ge to form conducting channels. These characteristics make this "40/60" stoichiometry optimal when using a germanium selenide chalcogenide glass with respect to the formation of a conducting channel and conductive pathway.
US 2003/0209971 A1 discloses a microelectronic programmable structure having an electrical property that can be variably programmed by manipulating an amount of energy supplied to the structure during a programming function.
US 2004/0042259 A1 discloses a resistance variable memory element having at least one silver-selenide layer in between glass layers, the glass layers are a chalcogenide glass having a GeₓSe₁₀₀₋ₓ composition. US 2003/0156452 A1 discloses a programmable multiple data state memory cell including a first electrode layer, a second electrode layer and a first layer of a metal-doped chalcogenide material disposed between the first and second electrode layers.

While germanium-chalcogenide (e.g., Ge₄₀Se₆₀) glass layers are highly desirable for PCRAM devices, other glasses may be desirable to improve switching properties or thermal limitations of the devices.

The chalcogenide glass material may be represented by AₓB₁₀₀₋ₓ, where A is a non-chalcogenide material selected from Groups 3-15 of the periodic table and B is a chalcogenide material from Group 16. The method of selecting a glass material includes: (1) selection of a non-chalcogenide component A from Groups 3-15 that will exhibit homopolar bonds; (2) selection of a chalcogenide component B from Group 16 for which component A will have a bonding affinity, relative to the A-A homopolar bonds; (3) selection of a stoichiometry (i.e., x of AₓB₁₀₀₋ₓ) that will allow the homopolar A-A bonds to form; and (4) confirmation that the glass AₓB₁₀₀₋ₓ, at the selected stoichiometry (i.e., x), will allow a conducting channel and a conductive pathway to form therein upon application of a conditioning voltage (when a metal-chalcogenide layer and metal ions are proximate the glass).

An exemplary memory device uses a germanium telluride glass backbone having a GeₓTe₁₀₀₋ₓ stoichiometry and a metal-chalcogenide layer proximate thereto for a memory cell. In a specific exemplary embodiment, x is between about 44 and about 53. Also, the metal-chalcogenide layer can be a tin selenide with a stoichiometry of about SnSe. Other layers may also be associated with this glass backbone and metal-chalcogenide layer.

### SUMMARY

The invention provides methods of forming a memory device, memory devices, a PCRAM memory cell and a processor system as defined in the claims.

The above and other features and advantages of the invention will be better understood from the following detailed description, which is provided in connection with the accompanying drawings.

### BRIEF DESCRIPTION OF THE DRAWINGS

FIGs.1-3 show for reference graphs of Raman shift analysis of germanium selenide glass, which may be used in selecting glass backbone materials ;

FIG. 4 shows as a reference an exemplary memory device not in accordance with the invention;

FIG. 5 shows an exemplary embodiment of a memory device in accordance with the invention;

FIGs. 6-11 show a cross-section of a wafer at various stages during the fabrication of the reference memory device (100) of FIG*.* 4;

FIG. 12 shows a resistance-voltage curve of a first (conditioning) write and second (programming) write for a 0.13 µm device;

FIG. 13 shows an exemplary processor-based system incorporating memory devices in accordance with the invention;

FIGs. 14a-14h are graphs showing experimental results of thermal testing conducted with devices fabricated in accordance with exemplary embodiments of the invention; and

FIG. 15 shows a graph of Raman shift analysis of germanium telluride glass.

### DETAILED DESCRIPTION

In the following detailed description, reference is made to various specific embodiments of the invention. These embodiments are described with sufficient detail to enable those skilled in the art to practice the invention.

The term "substrate" used in the following description may include any supporting structure including, but not limited to, a semiconductor substrate that has an exposed substrate surface. A semiconductor substrate should be understood to include silicon-on-insulator (SOI), silicon-on-sapphire (SOS), doped and undoped semiconductors, epitaxial layers of silicon supported by a base semiconductor foundation, and other semiconductor structures. When reference is made to a semiconductor substrate or wafer in the following description, previous process steps may have been utilized to form regions or junctions in or over the base semiconductor or foundation. The substrate need not be semiconductor-based, but may be any support structure suitable for supporting an integrated circuit, including, but not limited to, metals, alloys, glasses, polymers, ceramics, and any other supportive materials as is known in the art.

The term "chalcogenide" is intended to include various alloys, compounds, and mixtures of chalcogens (elements from Group 16 of the periodic table, e.g., sulfur (S), selenium (Se), tellurium (Te), polonium (Po), and oxygen (O)).

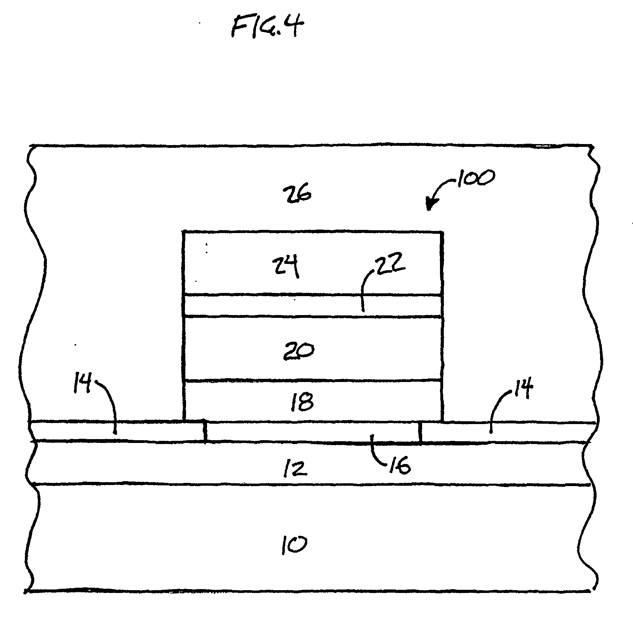

The backbone material (i.e., backbone glass layer 18 of FIG. 4 )may be represented by the formula AₓB₁₀₀₋ₓ, where A is a non-chalcogenide material selected from Groups 3-15, and preferably 13, 14, and 15, of the periodic table and B is a chalcogenide material. The glass backbone may also be represented by the formula (AₓB₁₀₀₋ₓ)C_{y}, where C represents one or more additional, optional components, which may be present in some glass formulations, but which may be omitted; therefore, the description hereafter will focus on two components (A and B) for simplicity sake. The ultimate choice for the material AₓB₁₀₀₋ₓ depends, in part, on the make up of an adjacent metal-chalcogenide layer (e.g., layer 20 of FIG. 4) with which it operationally engages. The component A should have an affinity for the chalcogenide component B, and preferably for the chalcogenide material (which is preferably also component B) of the metal-chalcogenide layer. Since Ge₄₀Se₆₀ glass has been experimentally observed to have good glass backbone properties in PCRAM devices, a backbone material represented by the formula AₓB₁₀₀₋ₓ should have properties similar to Ge₄₀Se₆₀ glass, such as homopolar bond properties and affinity of the non-chalcogenide component, e.g., Ge, for the chalcogenide component in the metal-chalcogenide layer.

Taking these characteristics into consideration, a primary consideration in selecting components A and B and the stoichiometry for a glass backbone material is that the resulting material contain thermodynamically unstable homopolar bonds of component A, meaning that the non-chalcogenide component A may form a bond with another component A in the glass, as initially formed, only if there is an insufficient amount of component B to satisfy the coordination number requirement for component A, which allows for the formation homopolar A-A bonds. The A-A homopolar bonds in such a glass material are thermodynamically unstable and will themselves break when the device is programmed and a conducting channel is formed in the glass backbone by the metal-chalcogenide layer when the chalcogenide component for the metal-chalcogenide layer bonds to the component A participating in the homopolar bonds. This property is dependent on the stoichiometry of the material AₓB₁₀₀₋ₓ in that excess chalcogenide component B will inhibit the formation of homopolar A-A bonds.

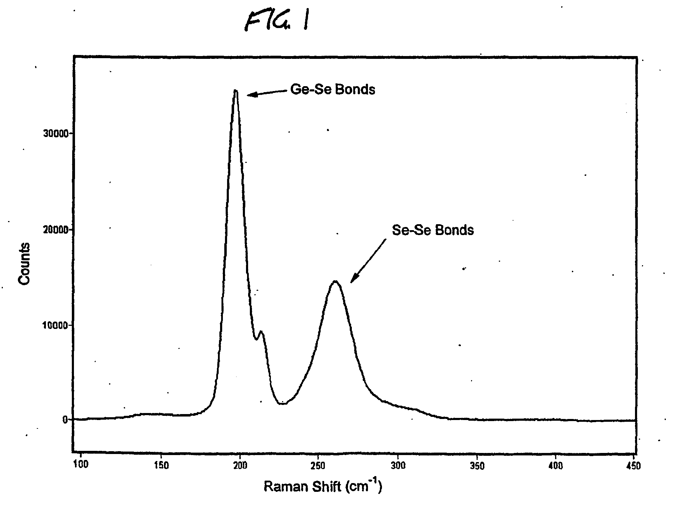

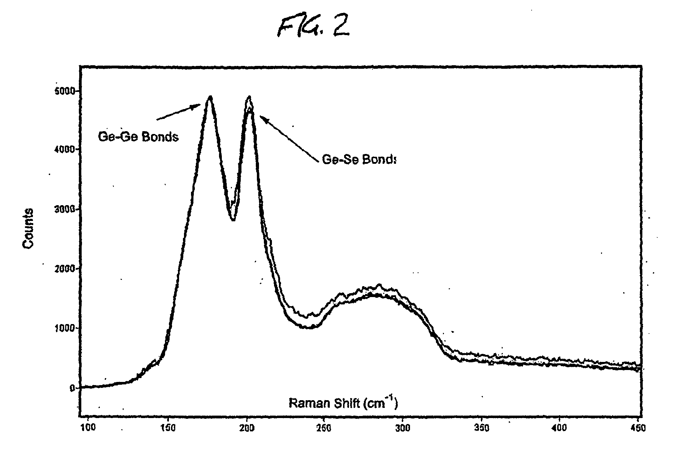

What "excess" chalcogenide component B means in relation to the material AₓB₁₀₀₋ₓ and its stoichiometry may be determined by whether the material exhibits the homopolar bonds or not. Raman spectroscopy can be a useful analytical tool for determining the presence of homopolar bonds when selecting a material AₓB₁₀₀₋ₓ for the glass backbone in PCRAM devices. Raman Spectroscopy is based on the Raman effect, which is the inelastic scattering of photons by molecules. A plot of Raman intensity (counts) vs. Raman shift (cm⁻¹) is a Raman spectrum, which is the basis for FIGs.1-3.

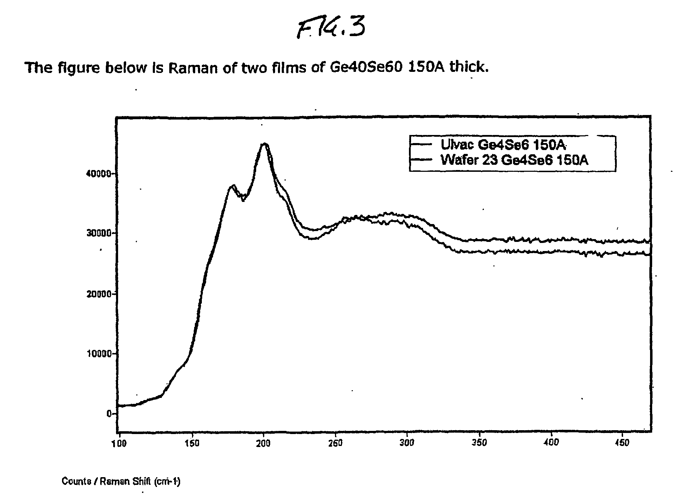

Referring now to FIG. 1, which is a Raman spectrum for bulk Ge₂₃Se₇₇ glass, it can be observed by the Raman Shift peaks at about 200 cm⁻¹ and at about 260 cm⁻¹ that the glass incorporates Ge-Se bonds and Se-Se (i.e., chalcogenide) bonds. This is an undesirable stoichiometry for the glass backbone since it lacks the homopolar Ge-Ge (i.e., non-chalcogenide) bonds desirable for switching in a device comprising a germanium selenide glass. Compare FIG. 1 to FIG. 2, the latter of which is a Raman spectrum for bulk Ge₄₀Se₆₀ glass, which shows a Raman Shift peak at about 175 cm⁻¹ that corresponds to Ge-Ge homopolar bonds and a peak at about 200 cm⁻¹ that corresponds to Ge-Se bonds. The prevalence of non-chalcogenide (i.e., Ge-Ge) homopolar bonds found in Ge₄₀Se₆₀ is a characteristic sought in materials for the glass backbone in PCRAM. This characteristic may also be seen in a thin film of Ge₄₀Se₆₀ using Raman spectra, as shown in FIG. 3. Similar comparisons of Raman spectra may be made for other materials AₓB₁₀₀₋ₓ of varying stoichiometries to find spectra showing peaks demonstrating homopolar bonding of the non-chalcogenide component (i.e., A-A) in the material, which indicates that it has suitable properties for a glass backbone.

Taking the aforementioned desired characteristics into consideration, the method of detecting a suitable glass backbone may be performed by the following steps: (1) selection of a non-chalcogenide component A from Groups 3-15 that will exhibit homopolar bonds; (2) selection of a chalcogenide component B from Group 16 for which component A will have a bonding affinity, relative to the A-A homopolar bonds; (3) selection of a stoichiometry (i.e., x of AₓB₁₀₀₋ₓ) that will provide for a thermodynamically unstable glass and will allow the homopolar A-A bonds to form; and (4) confirmation that the glass AₓB₁₀₀₋ₓ, at the selected stoichiometry (i.e., x), will allow a conducting channel and a conductive pathway to form therein upon applications of a conditioning voltage (when a metal-chalcogenide, e.g., M_{y}B_{100-y}, and metal ions are proximate the glass).

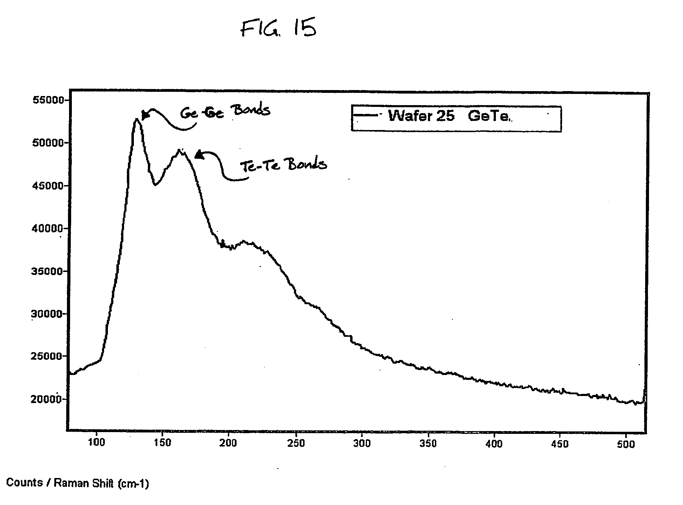

Using the above-discussed methodology for selecting glass backbone materials AₓB₁₀₀₋ₓ, at least four have been found preferable for use in PCRAM devices. These materials include arsenic selenide, represented by formula As₅₀Se₅₀, tin selenide, represented by formula Sn₅₀Se₅₀, antimony selenide, represented by formula SbₓSe₁₀₀₋ₓ, and germanium telluride, represented by formula GeₓTe₁₀₀₋ₓ. As shown by FIG. 15, the Raman shift peaks for germanium telluride glass are at about 140 counts/cm⁻¹ (for Ge-Ge bonds) and about 180 counts/cm⁻¹ (for Te-Te bonds), demonstrating at least one favorable characteristic of the glass for PCRAM. Although each of these exemplary materials include selenium or tellurium for component B, other chalcogenides may be used as well.

The invention is now explained with reference to the other figures, throughout which like reference numbers indicate like features. FIG. 4 shows an exemplary memory device 100 not falling under the scope of the present invention. The device 100 shown in FIG. 4 is supported by a substrate 10. Over the substrate 10, though not necessarily directly so, is a conductive address line 12, which serves as an interconnect for the device 100 shown and for a plurality of other similar devices of a portion of a memory array of which the shown device 100 is a part. It is possible to incorporate an optional insulting layer (not shown) between the substrate 10 and address line 12, and this may be preferred if the substrate 10 is semiconductor-based. The conductive address line 12 can be any material known in the art as being useful for providing an interconnect line, such as doped polysilicon, silver (Ag), gold (Au), copper (Cu), tungsten (W), nickel (Ni), aluminum (Al), platinum (Pt), titanium (Ti), and other materials.

Over the address line 12 is a first electrode 16, which can be defined within an insulating layer 14 (or may be a common blanket electrode layer; not shown), which is also over the address line 12. This electrode 16 can be any conductive material that will not migrate into chalcogenide glass, but is preferably tungsten (W). The insulating layer 14 should not allow the migration of metal ions and can be an insulating nitride, such as silicon nitride (Si₃N₄), a low dielectric constant material, an insulating glass, or an insulating polymer, but is not limited to such materials.

A memory element, i.e., the portion of the memory device 100 which stores information, is formed over the first electrode 16. In the example shown in FIG. 4, a chalcogenide glass layer 18 is provided over the first electrode 16. The chalcogenide glass layer 18 has the stoichiometric formula AₓB₁₀₀₋ₓ, with A being a non-chalcogenide component and B being a chalcogenide component as discussed above. The material AₓB₁₀₀₋ₓ may be many materials with the appropriate characteristics (e.g., homopolar bonds, homopolar bond strength, thermodynamic instability, etc.) and an appropriate stoichiometry, as discussed above, but is preferably be selected from Sn₅₀Se₆₀, SbₓSe₁₀₀₋ₓ, As₅₀Se₅₀, and GeₓTe₁₀₀₋ₓ, which have been found to be suitable by following the methodology discussed above. Germanium telluride with a formula GeₓTe₁₀₀₋ₓ, where x is between about 44 and 53; is the preferred material for layer 18. More preferably, x is between 46 and 51 and most preferably, x is about 47. This may be written as Ge₄₆Te₅₄ to Ge₅₁Te₄₉. Germanium telluride is a particularly good selection for the chalcogenide glass layer 18 because, as shown by the Raman data in FIG. 15, it exhibits the Ge-Ge homopolar bonds desirable for such glass. Also, when used with a metal-chalcogenide layer 20 of tin selenide (SnSe), the tin selenide allows for the formation of a Ge-Se bond and the development of a channel for metal (e.g., Ag) ion migration during operation of the memory device.

The layer of chalcogenide glass 18 is preferably between about 10nm (100 Å) and about 100nm (1000 Å) thick, most preferably about 30nm (300 Å) thick. Layer 18 need not be a single layer of glass, but may also be comprised of multiple sub-layers of chalcogenide glass having the same or different stoichiometries. This layer of chalcogenide glass 18 is in electrical contact with the underlying electrode 16.

Over the chalcogenide glass layer 18 is a layer of metal-chalcogenide 20, which may be any combination of metal component M, which may be selected from any metals, and chalcogenide component B, which is preferably the same chalcogenide as in the glass backbone layer 18, and may be represented by the formula M_{y}B_{100-y}. As with the glass backbone layer 18 material, other components may be added, but the metal-chalcogenide will be discussed as only two components M and B for simplicity sake. The metal-chalcogerude may be, for example, silver selenide (Ag_{y}Se, y being about 20) or, preferably, tin selenide (Sn_{10+/-y}Se, where y is between about 10 and 0). The metal-chalcogenide layer 20 is preferably about 50nm (500 Å) thick; however, its thickness depends, in part, on the thickness of the underlying chalcogenide glass layer 18. The ratio of the thickness of the metal-chalcogenide layer 20 to that of the underlying chalcogenide glass layer 18 should be between about 5:1 and about 1:1, more preferably about 2.5:1.

Still referring to FIG. 4, a metal layer 22 is provided over the metal-chalcogenide layer 20, with the metal of layer 22 preferably incorporating some silver, if not being exclusively silver. The metal layer 22 should be about 50nm (500 Å) thick. The metal layer 22 assists the switching operation of the memory device 100. Over the metal layer 22 is a second electrode 24. The second electrode 24 can be made of the same material as the first electrode 16, but is not required to be so. In the exemplary device shown in FIG. 4, the second electrode 24 is preferably tungsten (W). The device(s) 100 may be isolated by an insulating layer 26.

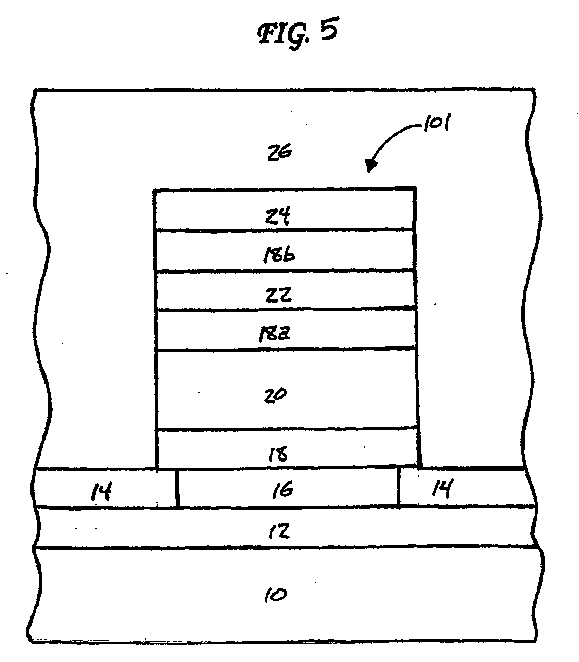

FIG. 5 shows an exemplary embodiment of a memory device 101 constructed in accordance with the invention. Memory device 101 has many similarities to memory device 100 of FIG. 4 and layers designated with like reference numbers are preferably made of the same materials and have the same thicknesses as those described in relation to the embodiment shown in FIG. 4. For example, the first electrode 16 is preferably tungsten. However, for the first chalcogenide glass layer 18 germanium telluride is selected as layer, material AₓB₁₀₀₋ₓ it is preferably about 15 nm (150 Å) thick. Also, the metal-chalcogenide layer 20 is made of tin selenide; it is preferably about 47nm (470 Å) thick. The metal layer 22 preferably contains some silver, but can be mostly or wholly silver; it is preferably about 20nm (200 Å) thick. The primary difference between device 100 and device 101 is the addition to device 101 of additional second and third chalcogenide layers 18a and 18b.

The second chalcogenide glass layer 18a is formed over the metal-chalcogenide layer 20 and is preferably about 15nm (150 Å) thick. Over this second chalcogenide glass layer 18a is metal layer 22. Over the metal layer 22 is a third chalcogenide glass layer 18b, which is preferably about 10nm (100 Å) thick. The third chalcogenide glass layer 18b provides an adhesion layer for subsequent electrode formation. As with layer 18 of FIG. 4, layers 18a and 18b are not necessarily a single layer, but may be comprised of multiple sub-layers. Additionally, the second and third chalcogenide layers 18a and 18b may be a different glass material from the first chalcogenide glass layer 18 or from each other. Glass material preferred for layers 18a and 18b is germanium selenide (GeₓSe₁₀₀₋ₓ), more preferably Ge₂Se₃, but other materials may be useful as well, including germanium telluride (GeₓTe₁₀₀₋ₓ), arsenic selenide (AsₓSe₁₀₀₋ₓ), tin selenide (SnₓSe₁₀₀₋ₓ), antimony selenide (SbₓSe₁₀₀₋ₓ), germanium sulfide (GeₓS₁₀₀₋ₓ), and combinations of germanium (Ge), silver (Ag), and selenium (Se). The second electrode 24 is preferably tungsten (W), but may be other metals also.

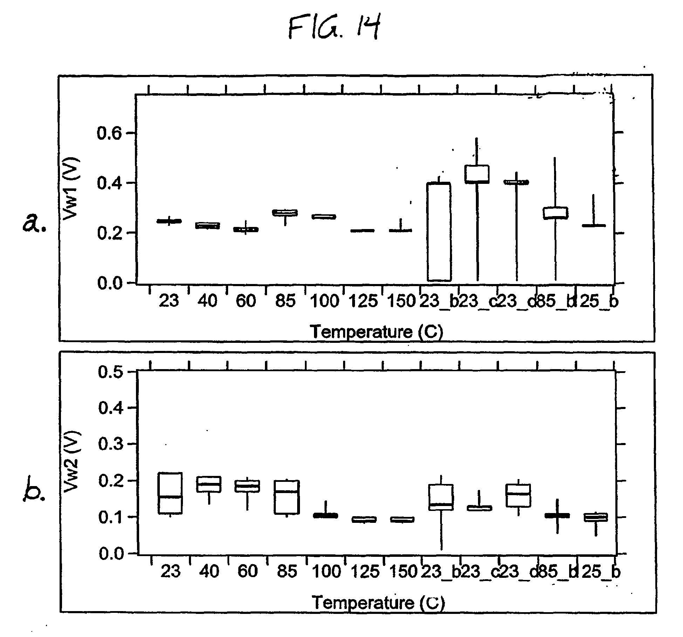

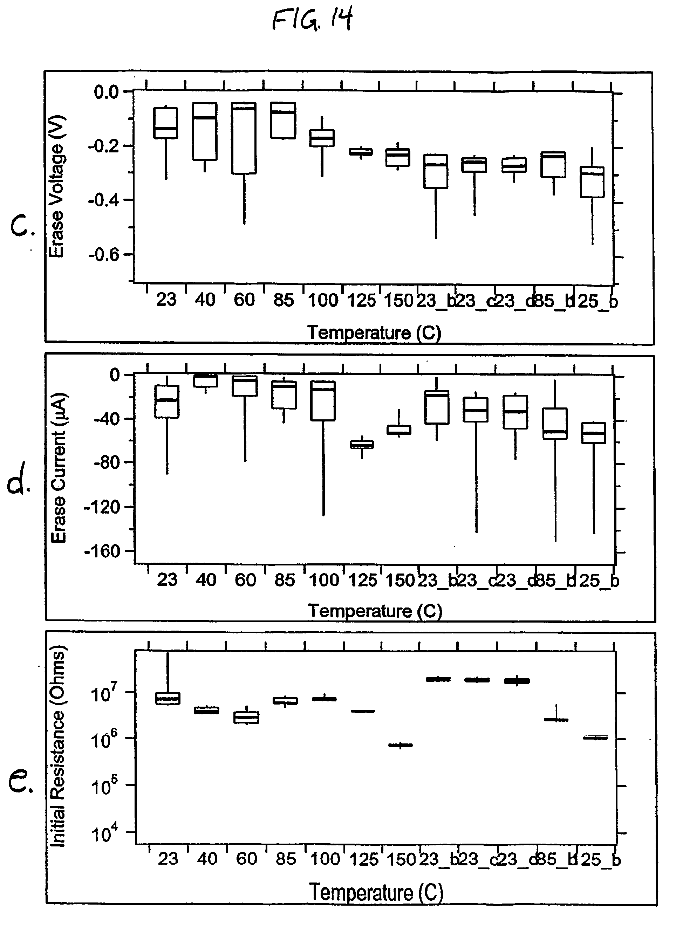

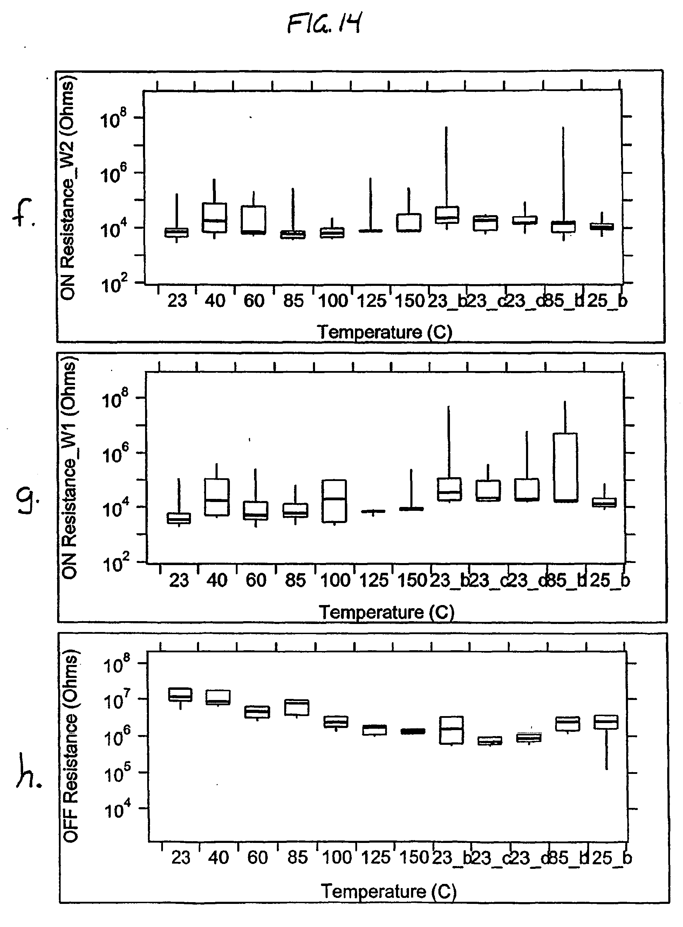

As shown by FIGs.14a-14h, PCRAM devices in accordance with the above-discussed embodiment (FIG. 5) were experimentally tested for memory operation under varied thermal conditions. Each chart (FIGs. 14a-14h) represents a set of thermal tests on a respective PCRAM device. Similar to the device shown in FIG. 5, each tested device had a tungsten (W) first electrode (e.g., layer 16), a 30nm (300Å) germanium telluride (GeₓTe₁₀₀₋ₓ, x ≅ 44 to 53) layer (e.g., layer 18) thereover, a 90nm (900Å) tin selenide (SnSe) layer (e.g., layer 20) thereover, a 15nm (150Å) germanium selenide (Ge₂Se₃) layer (e.g., layer 18a) thereover, a 50nm (500Å) silver (Ag) layer (e.g., layer 22) thereover, a 10nm (100Å) germanium selenide (Ge₂Se₃) layer (e.g., layer 18b) thereover, and a tungsten (W) second electrode (e.g., layer 24).

The testing was conducted by positioning wafers, which supported the PCRAM devices, on a temperature-controllable chuck and DC programming ten (10) devices at the temperatures shown on the charts in FIGs. 14a-14h. The DC probing procedure was conducted on each device as follows: (1) sweep potential from 0 to 800 mV and read resistance of cell at 10 mV to determine the initial resistance (Ri); (2) sweep the potential from 0 to 10 mV and record the resistance at 10 mV to obtain the write resistance (Rw1); (3) sweep the device from 0 to -1 V and record the potential at which the device erased and the current at that erase potential to determine the erase voltage and erase current; (4) sweep the device from 0 to 800 mV and read the resistance at 10 mV (this is the Rerase) and record the potential at which the device switched (i.e., was written; the Vw2); and (5) sweep the potential from 0 to 10 mV and record the resistance at 10 mV (this is the Rw2). The charts of FIGs. 14a-14h show these measured parameters (i.e., Vw1, Vw2, Ri, erase current, erase voltage, Rw1, Rw2, Rerase) for 10 experimental devices constructed in accordance with the invention at the temperatures shown along the x-axis of the charts. The results show that germanium tellurium based PCRAM cells have thermal tolerances suitable for use in memory devices.

The above-discussed embodiments are exemplary embodiments of the invention; however, other exemplary embodiments may be used which combine the first electrode layer 16 and address line layer 12. Another exemplary embodiment may use blanket layers (e.g., layers 16, 18, 20, and 22 of FIG. 4) of the memory cell body, where the memory cell is defined locally by the position of the second electrode 24 over the substrate 10. Another exemplary embodiment may form the memory device within a via. Additional layers, such as barrier layers or alloy-controlling layers, not specifically disclosed in the embodiments shown and discussed above, may be added to the devices in accordance with the invention without departing from the scope thereof.

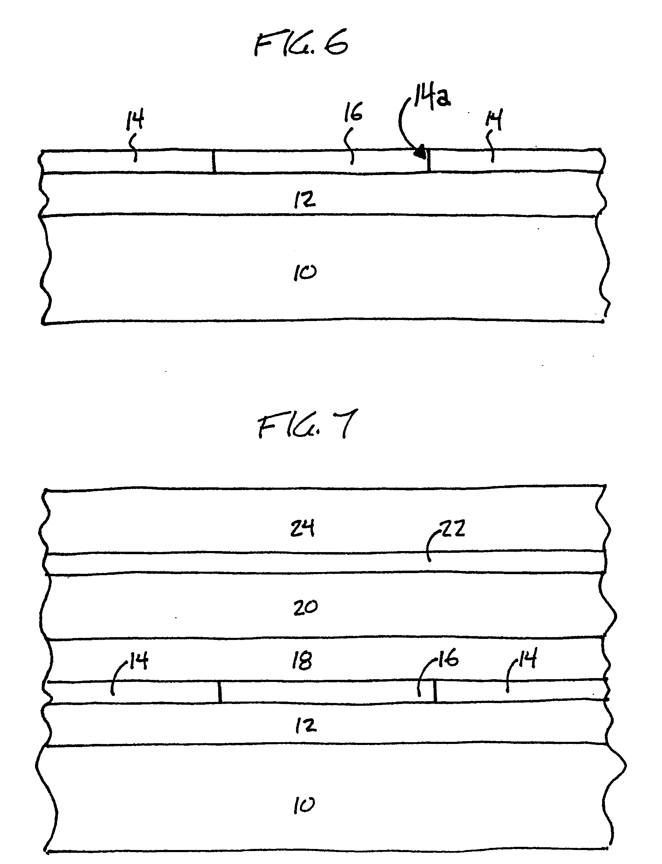

FIGs. 6-11 illustrate a cross-sectional view of a wafer during the fabrication of a memory device 100 as shown by FIG. 4. Although the processing steps shown in FIGs. 6-11 most specifically refer to the reference memory device 100 of FIG. 4, the methods and techniques discussed may also be used to fabricate memory devices of other embodiments (e.g., device 101 of FIG. 5) as would be understood by a person of ordinary skill in the art.

As shown by FIG. 6, a substrate 10 is provided. As indicated above, the substrate 10 can be semiconductor-based or another material useful as a supporting structure as is known in the art. If desired, an optional insulating layer (not shown) may be formed over the substrate 10; the optional insulating layer may be silicon nitride or other insulating materials used in the art. Over the substrate 10 (or optional insulating layer, if desired), a conductive address line 12 is formed by depositing a conductive material, such as doped polysilicon, aluminum, platinum, silver, gold, nickel, but preferably tungsten, patterning one or more conductive lines, for instance with photolithographic techniques, and etching to define the address line 12. The conductive material may be deposited by any technique known in the art, such as sputtering, chemical vapor deposition, plasma enhanced chemical vapor deposition, evaporation, or plating.

Still referring to FIG. 6, over the address line 12 is formed an insulating layer 14. This layer 14 can be silicon nitride, a low dielectric constant material, or many other insulators known in the art that do not allow metal (e.g., silver, copper, or other metal) ion migration, and may be deposited by any method known in the art. An opening 14a in the insulating layer is made, for example, by photolithographic and etching techniques, thereby exposing a portion of the underlying address line 12. Over the insulating layer 14, within the opening 14a, and over the address line 12 is formed a conductive material, preferably tungsten (W). A chemical mechanical polishing step may then be utilized to remove the conductive material from over the insulating layer 14, to leave it as a first electrode 16 over the address line 12, and planarize the wafer.

FIG. 7 shows the cross-section of the wafer of FIG. 6 at a subsequent stage of processing A series of layers making up the reference memory device 100 (FIG. 4) are blanket-deposited over the wafer. A chalcogenide glass layer 18 is formed to a preferred thickness of about 30nm (300Å) over the first electrode 16 and insulating layer 14. The chalcogenide glass layer 18 is GexTe₁₀₀₋ₓ, where x is between about 44 to 53, but may also be selected from other materials such as As₅₀Se₅₀, Sn₅₀Se₅₀, and SbₓSe₁₀₀₋ₓ, and as described above, may be selected from many materials AₓB₁₀₀₋ₓ with appropriate characteristics and of an appropriate stoichiometry for memory function.

The steps in selecting a chalcogenide glass layer 18 material are: (1) selection of a non-chalcogenide component A from Groups 3-15 that will exhibit homopolar bonds; (2) selection of a chalcogenide component B from Group 16 for which component A will have a bonding affinity, relative to the A-A homopolar bonds; (3) selection of a stoichiometry (i.e., x of AₓB₁₀₀₋ₓ) that will provide for thermodynamically unstable homopolar A-A bonds; and (4) confirmation that the glass AₓB₁₀₀₋ₓ, at the selected stoichiometry (i.e., x), will allow a conducting channel and a conductive pathway to form therein upon application of a conditioning voltage when a metal-chalcogenide layer 20 is proximate the glass layer 18. Once the materials are selected, deposition of the chalcogenide glass layer 18 may be accomplished by any suitable method, such as evaporative techniques or chemical vapor deposition; however, the preferred technique utilizes either sputtering or co-sputtering.

Still referring to FIG. 7, a metal-chalcogenide layer 20, e.g., M_{y}B_{100-y}, is formed over the chalcogenide glass layer 18. The metal-chalcogenide layer 20 is preferably tin selenide (SnSe), particularly when germanium telluride is used as the chalcogenide glass layer 18. Physical vapor deposition, chemical vapor deposition, coevaporation, sputtering, or other techniques known in the art may be used to deposit layer 20 to a preferred thickness of about 50nm (500 Å). Again, the thickness of layer 20 is selected based, in part, on the thickness of layer 18 and the ratio of the thickness of the metal-chalcogenide layer 20 to that of the underlying chalcogenide glass layer 18 is preferably from about 5:1 to about 1:1, more preferably about 2.5:1. It should be noted that, as the processing steps outlined in relation to FIGs. 6-11 may be adapted for the formation of other devices in accordance the invention, e.g., the layers may remain in blanket-deposited form, a barrier or alloy-control layer may be formed adjacent to the metal-chalcogenide layer 20, on either side thereof, or the layers may be formed within a via.

Still referring to FIG. 7, a metal layer 22 is formed over the metal-chalcogenide layer 20. The metal layer 22 preferably incorporates at least some silver (Ag), if not exclusively being silver (Ag), but may be other metals as well, such as copper (Cu) or a transition metal, and is formed to a preferred thickness of about 30nm (300 Å). The metal layer 22 may be deposited by any technique known in the art.

Still referring to FIG. 7, over the metal layer 22, a conductive material is deposited for a second electrode 24. Again, this conductive material may be any material suitable for a conductive electrode, but is preferably tungsten; however, other materials may be used such as titanium nitride or tantalum, for example.

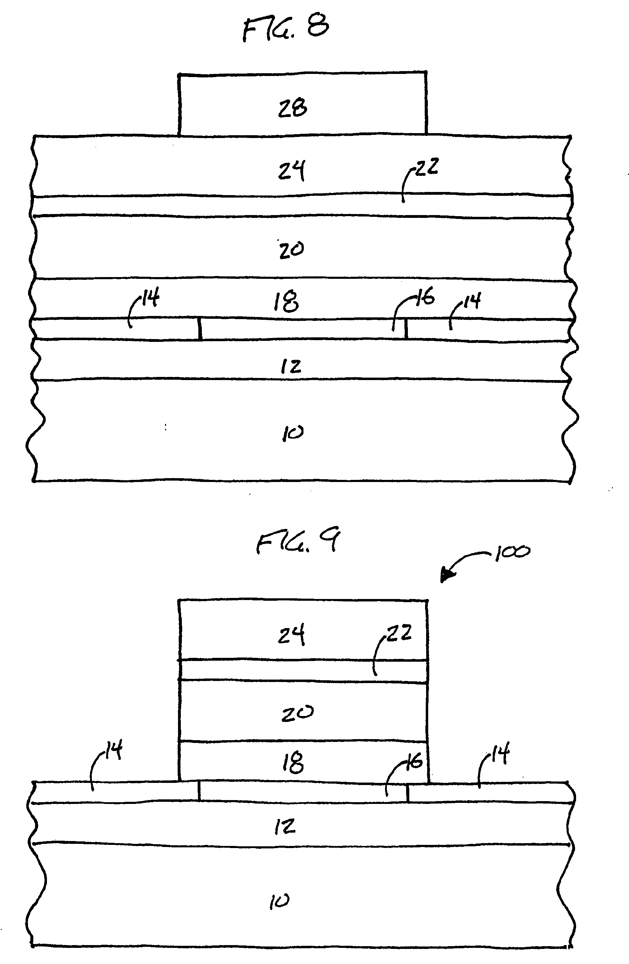

Now referring to FIG. 8, a layer of photoresist 28 is deposited over the top electrode 24 layer, masked and patterned to define the stacks for the memory device 100, which is but one of a plurality of like memory devices of a memory array. An etching step is used to remove portions of layers 18, 20, 22, and 24, with the insulating layer 14 used as an etch stop, leaving stacks as shown in FIG. 9. The photoresist 28 is removed, leaving a substantially complete memory device 100, as shown by FIG. 9. An insulating layer 26 may be formed over the device 100 to achieve a structure as shown by FIGs. 4, 10, and 11. This isolation step can be followed by the forming of connections (not shown) to other circuitry of the integrated circuit (e.g., logic circuitry, sense amplifiers, etc.) of which the memory device 100 is a part, as is known in the art.

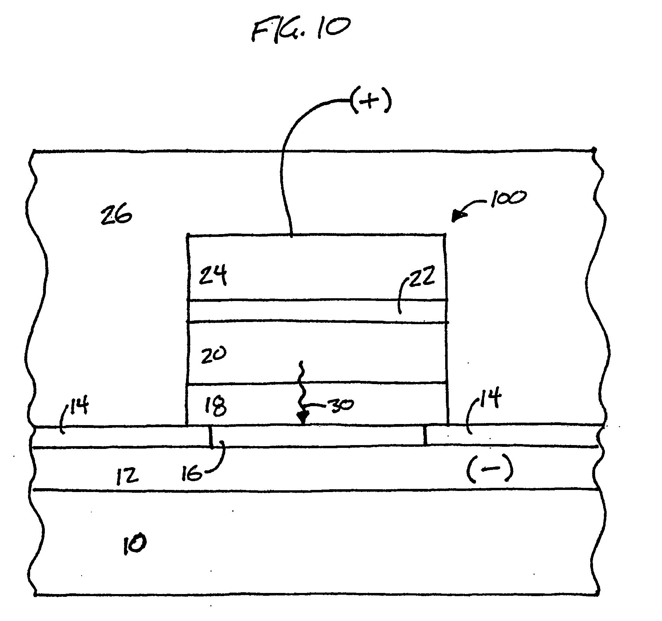

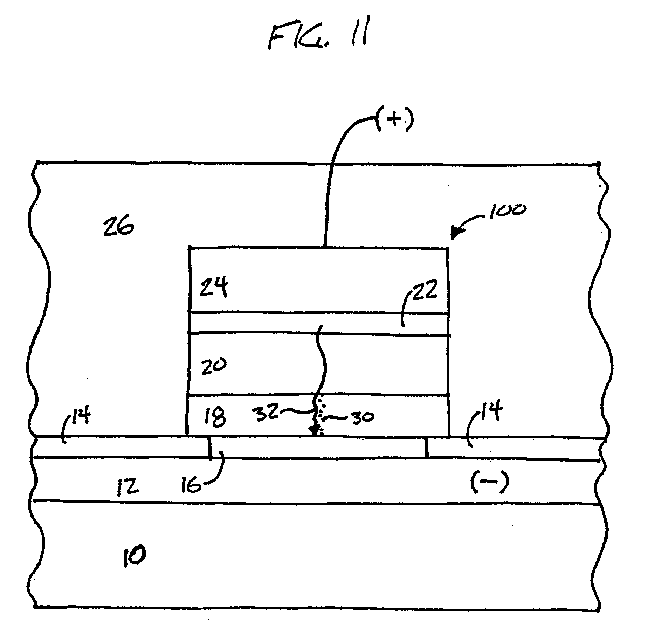

As shown in FIG. 10, a conditioning step is performed by applying a voltage pulse of about 0.20 V to incorporate material from the metal-chalcogenide layer 20 into the chalcogenide glass layer 18 to form a conducting channel 30 in the chalcogenide glass layer 18. The conducting channel 30 will support a conductive pathway 32, as shown in FIG.11, upon application of a programming pulse of about 0.17 V during operation of the memory device 100.

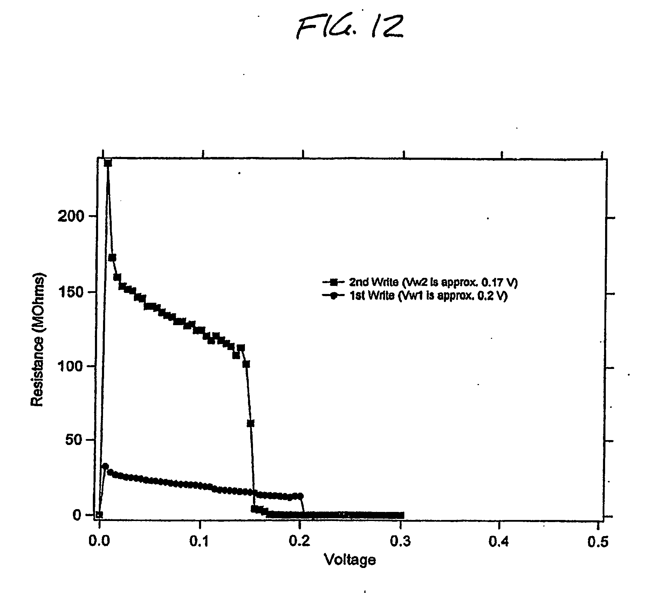

FIG.12 shows a resistance-voltage curve of a first write, which corresponds to a conditioning voltage, and a second write, which corresponds to a programming voltage, for a 0.13 µm device such as device 100 shown in FIG. 4 The device represented by the curve of FIG.12 has an As₅₀Se_{50.} chalcogenide glass layer 18 (See FIG. 4). FIG.12 shows that the first write is at a slightly higher potential than the second write (i.e., about 0.2 V. compared to about 0.17 V, respectively). This is because the first write conditions the device in accordance with the processing shown at FIG. 10 by forming a conducting channel 30, which remains intact after this first write. The second write requires less voltage because the stable conducting channel 30 is already formed by the conditioning write and the conductive pathway 32 is formed more easily. Application of these write voltages programs the device to a non-volatile higher conductivity, lower resistivity, memory state. These observed programming parameters utilizing a chalcogenide glass layer 18 selected in accordance with the invention show that the tested devices work as well as when Ge₄₀Se₆₀ is used as the glass backbone.

The erase potential for a device having an As₅₀Se₅₀ chalcogenide glass layer (e.g., layer 18) is also similar to a device having Ge₄₀Se₆₀ glass. This erase voltage curve is not shown in FIG. 12; however, the erase potential is about -0.06 V, which returns the device to a non-volatile higher resistance, lower conductivity memory state.

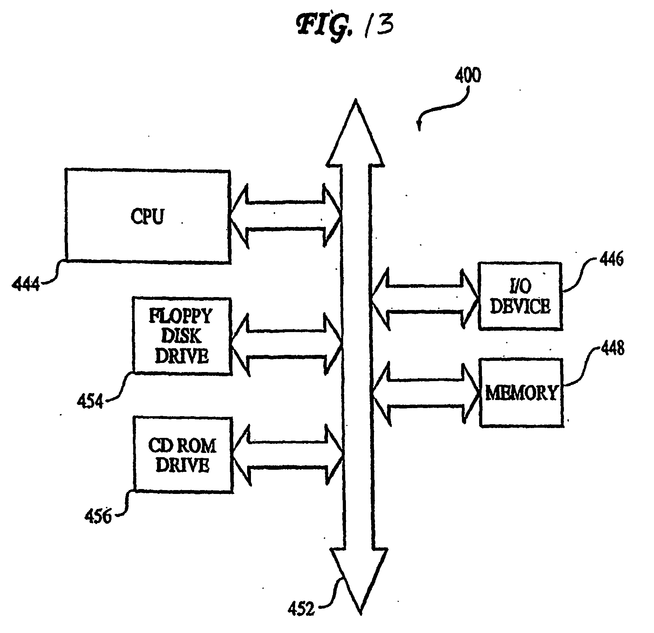

FIG.13 illustrates a typical processor system 400 which includes a memory circuit 448, e.g., a PCRAM device, which employs resistance variable memory devices (e.g., device 101) fabricated in accordance with an embodiment the invention. A processor system, such as a computer system, generally comprises a central processing unit (CPU) 444, such as a microprocessor, a digital signal processor, or other programmable digital logic devices, which communicates with an input/output (I/O) device 446 over a bus 452. The memory circuit 448 communicates with the CPU 444 over bus 452 typically through a memory controller.

In the case of a computer system, the processor system may include peripheral devices such as a floppy disk drive 454 and a compact disc (CD) ROM drive 456, which also communicate with CPU 444 over the bus 452. Memory circuit 448 is preferably constructed as an integrated circuit, which includes one or more resistance variable memory devices. If desired, the memory circuit 448 may be combined with the processor, for example CPU 444, in a single integrated circuit.

The above description and drawings should only be considered illustrative of exemplary embodiments that achieve the features and advantages of the invention. Modification and substitutions to specific process conditions and structures can be made without departing from the scope of the invention. Accordingly, the invention is not to be considered as being limited by the foregoing description and drawings, but is only limited by the scope of the appended claims.

## Claims

1. A method of forming a memory device (101), comprising:
providing a first electrode (16) and a second electrode (24);
providing a metal-chalcogenide layer (20) between said first and second electrodes,
wherein said metal-chalcogenide layer comprises tin selenide;
providing a first chalcogenide glass layer (18) of germanium telluride glass between said first and second electrode and in contact with said metal-chalcogenide layer;
providing a metal layer (22) between said metal-chalcogenide layer and said second electrode; and
providing a second chalcogenide glass layer (18a) between said metal-chalcogenide layer and said metal layer.

2. The method of claim 1, wherein said metal-chalcogenide layer is between said first chalcogenide glass layer and said second electrode.

3. The method of claim 1, wherein said metal layer comprises silver.

4. The method of claim 1, further comprising providing a third chalcogenide glass layer (18b) between said metal layer and said second electrode.

5. The method of claim 1, wherein said germanium telluride glass has a stoichiometric formula GeₓTe₁₀₀₋ₓ, where x is about 44 to about 53.

6. The method of claim 1, wherein said germanium telluride glass has a stoichiometric formula GeₓTe₁₀₀₋ₓ, where x is about 46 to about 51.

7. The method of claim 1, wherein said germanium telluride glass has a stoichiometric formula GeₓTe₁₀₀₋ₓ, where x is about 47.

8. The method of claim 1, further comprising:
forming the first electrode over a substrate;
forming the metal layer over the second chalcogenide glass layer; and
forming an adhesion layer (18b) over the metal layer,
wherein said metal layer comprises silver.

9. The method of claim 8, wherein said germanium telluride glass has a stoichiometric formula GeₓTe₁₀₀₋ₓ, where x is about 44 to about 53.

10. The method of claim 8, wherein said germanium telluride glass has a stoichiometric formula GeₓTe₁₀₀₋ₓ, where x is about 46 to about 51.

11. The method of claim 8, wherein said germanium telluride glass has a stoichiometric formula GeₓTe₁₀₀₋ₓ, where x is about 47.

12. The method of claim 8, wherein said first chalcogenide glass layer is in contact with said first electrode.

13. The method of claim 8, wherein the various layers of said memory cell are arranged vertically.

14. The method of claim 8, wherein said second chalcogenide glass layer is formed of Ge₂Se₃.

15. The method of claim 8, wherein said adhesion layer is formed of Ge₂Se₃.

16. The method of claim 8, wherein:
the first and second electrodes are tungsten electrodes;
said germanium telluride glass has a stoichiometric formula GeₓTe₁₀₀₋ₓ, x being between about 44 and about 53;
the second chalcogenide glass layer comprises germanium selenide and is formed over said metal-chalcogenide layer comprising tin selenide;
the adhesion layer comprises germanium selenide; and
further comprising forming a conducting channel in said first chalcogenide glass layer.

17. A memory device (101), comprising:
a first electrode (16);
a second electrode (24);
a memory element between said first and said second electrodes, said memory element comprising a first chalcogenide glass layer (18) of germanium telluride glass and a metal-chalcogenide layer (20) between said first chalcogenide glass layer and said second electrode, wherein said metal-chalcogenide layer comprises tin selenide;
a metal layer (22) between said metal-chalcogenide layer and said second electrode; and
a second chalcogenide glass layer (18a) between said metal-chalcogenide layer and said metal layer.

18. The memory device of claim 17, wherein said germanium telluride glass has a stoichiometric formula GeₓTe₁₀₀₋ₓ, where x is about 44 to about 53.

19. The memory device of claim 17, wherein said germanium telluride glass has a stoichiometric formula GeₓTe₁₀₀₋ₓ, where x is about 46 to about 51.

20. The memory device of claim 17, wherein said germanium telluride glass has a stoichiometric formula GeₓTe₁₀₀₋ₓ, where x is about 47.

21. The memory device of claim 17, further comprising a conducting channel (30) within said first chalcogenide glass layer, said conducting channel comprising said metal-chalcogenide material.

22. The memory device of claim 21, further comprising a conductive pathway (32) associated with said conducting channel (30), said conductive pathway being provided when said memory device is programmed to a first memory state.

23. The memory device of claim 17, further comprising a third chalcogenide glass layer (18b) between said metal layer and said second electrode.

24. The memory device of claim 17, wherein said memory device is part of a processor system (400).

25. The memory device of claim 17, further comprising:
a substrate (10) wherein the first electrode is over the substrate; and
a third chalcogenide glass layer (18b) over the metal layer, wherein the third chalcogenide glass layer comprises germanium selenide,
and wherein:
the first chalcogenide glass layer of germanium telluride glass is over said first electrode;
the metal-chalcogenide layer is over said first chalcogenide glass layer;
the second chalcogenide glass layer is over said metal-chalcogenide layer, and comprises germanium selenide;
the metal layer is over said second chalcogenide glass layer, and the metal layer comprises silver; and
the second electrode is over said third chalcogenide glass layer.

26. The memory device of claim 25, wherein said germanium telluride glass has a stoichiometric formula GeₓTe₁₀₀₋ₓ, where x is about 44 to about 53.

27. The memory device of claim 25, wherein said germanium telluride glass has a stoichiometric formula GeₓTe₁₀₀₋ₓ, where x is about 46 to about 51.

28. The memory device of claim 25, wherein said germanium telluride glass has a stoichiometric formula GeₓTe₁₀₀₋ₓ, where x is about 47.

29. The memory device of claim 25, further comprising a conducting channel within said first chalcogenide glass layer, said conducting channel comprising said metal-chalcogenide material.

30. The memory device of claim 29, further comprising a conductive pathway associated with said conducting channel, said conductive pathway being provided when said memory device is programmed to a first memory state.

31. The memory device of claim 25, wherein said second and third chalcogenide glass layers comprise Ge₂Se₃.

32. The memory device of claim 25, wherein said layers making up said device are stacked vertically.

33. The memory device of claim 25, wherein said layers making up said device are in contact with one another.

34. A PCRAM memory cell, comprising the device of claim 25 wherein; the first and second electrodes are tungsten electrodes; said germanium telluride glass has a stoichiometric formula GeₓTe₁₀₀₋ₓ, x being between about 44 and about 53; and there is a conducting channel in said first chalcogenide glass layer.

35. A processor system, comprising:
a processor and a memory device; wherein said memory device is as defined in any of claims 17 to 23.

## Patentansprüche

1. Verfahren zum Bilden einer Speichereinheit (101), umfassend:
das Bereitstellen einer ersten Elektrode (16) und einer zweiten Elektrode (24),
das Bereitstellen einer Metallchalkogenidschicht (20) zwischen der ersten und
zweiten Elektrode, wobei die Metallchalkogenidschicht Zinnselenid umfaßt,
das Bereitstellen einer ersten Chalkogenidglasschicht (18) von Germaniumtelluridglas zwischen der ersten und zweiten Elektrode und in Kontakt mit der Metallchalkogenidschicht,
das Bereitstellen einer Metallschicht (22) zwischen der Metallchalkogenidschicht und der zweiten Elektrode, und
das Bereitstellen einer zweiten Chalkogenidglasschicht (18a) zwischen der Metallchalkogenidschicht und der Metallschicht.

2. Verfahren gemäß Anspruch 1, wobei die Metallchalkogenidschicht zwischen der ersten Chalkogenidglasschicht und der zweiten Elektrode ist.

3. Verfahren gemäß Anspruch 1, wobei die Metallschicht Silber umfaßt.

4. Verfahren gemäß Anspruch 1, weiter umfassend eine dritte Chalkogenidglasschicht (18b) zwischen der Metallschicht und der zweiten Elektrode.

5. Verfahren gemäß Anspruch 1, wobei das Germaniumtelluridglas eine stöchiometrische Formel GeₓTe1₀₀₋ₓ aufweist, wobei x etwa 44 bis etwa 53 ist.

6. Verfahren gemäß Anspruch 1, wobei das Germaniumtelluridglas eine stöchiometrische Formel GeₓTe₁₀₀₋ₓ aufweist, wobei x etwa 46 bis etwa 51 ist.

7. Verfahren gemäß Anspruch 1, wobei das Germaniumtelluridglas eine stöchiometrische Formel GeₓTe₁₀₀₋ₓ aufweist, wobei x etwa 47 ist.

8. Verfahren gemäß Anspruch 1, weiter umfassend:
das Bilden der ersten Elektrode über einem Substrat,
das Bilden der Metallschicht über der zweiten Chalkogenidglasschicht, und
das Bilden einer Haftschicht (18b) über der Metallschicht,
wobei die Metallschicht Silber umfaßt.

9. Verfahren gemäß Anspruch 8, wobei das Germaniumtelluridglas eine stöchiometrische Formel GeₓTe₁₀₀₋ₓ aufweist, wobei x etwa 44 bis etwa 53 ist.

10. Verfahren gemäß Anspruch 8, wobei das Germaniumtelluridglas eine stöchiometrische Formel GeₓTe₁₀₀₋ₓ aufweist, wobei x etwa 46 bis etwa 51 ist.

11. Verfahren gemäß Anspruch 8, wobei das Germaniumtelluridglas eine stöchiometrische Formel GeₓTe₁₀₀₋ₓ aufweist, wobei x etwa 47 ist.

12. Verfahren gemäß Anspruch 8, wobei die erste Chalkogenidglasschicht in Kontakt mit der ersten Elektrode ist.

13. Verfahren gemäß Anspruch 8, wobei die verschiedenen Schichten der Speichereinheit vertikal angeordnet sind.

14. Verfahren gemäß Anspruch 8, wobei die zweite Chalkogenidglasschicht aus Ge₂Se₃ gebildet ist.

15. Verfahren gemäß Anspruch 8, wobei die Haftschicht aus Ge₂Se₃ gebildet ist.

16. Verfahren gemäß Anspruch 9, wobei:
die erste und zweite Elektrode Wolframelektroden sind,
das Germaniumtelluridglas eine stöchiometrische Formel GeₓTe₁₀₀₋ₓ aufweist,
wobei x zwischen etwa 44 und etwa 53 ist, die zweite Chalkogenidglasschicht Germaniumselenid umfaßt und über der Metallchalkogenidschicht, umfassend Zinnselenid, gebildet ist,
wobei die Haftschicht Germaniumselenid umfaßt, und weiter umfassend das Bilden eines leitenden Kanals in der ersten Chalkogenidglasschicht.

17. Speichereinheit (101), umfassend:
eine erste Elektrode (16),
eine zweite Elektrode (24),
ein Speicherelement zwischen der ersten und zweiten Elektrode, wobei das Speicherelement eine erste Chalkogenidglasschicht (18) von Germaniumtelluridglas und eine Metallchalkogenidschicht (20) zwischen der ersten Chalkogenidglasschicht und der zweiten Elektrode umfaßt, wobei die MetallChalkogenidschicht Zinnselenid umfaßt,
eine Metallschicht (22) zwischen der Metallchalkogenidschicht und der zweiten Elektrode, und
eine zweite Chalkogenidglasschicht (18a) zwischen der Metallchalkogenidschicht und der Metallschicht.

18. Speichereinheit gemäß Anspruch 17, wobei das Germaniumtelluridglas eine stöchiometrische Formel GeₓTe₁₀₀₋ₓ aufweist, wobei x etwa 44 bis etwa 53 ist.

19. Speichereinheit gemäß Anspruch 17, wobei das Germaniumtelluridglas eine stöchiometrische Formel GeₓTe₁₀₀₋ₓ aufweist, wobei x etwa 46 bis etwa 51 ist.

20. Speichereinheit gemäß Anspruch 17, wobei das Germaniumtelluridglas eine stöchiometrische Formel GeₓTe₁₀₀₋ₓ aufweist, wobei x etwa 47 ist.

21. Speichereinheit gemäß Anspruch 17, weiter umfassend einen leitenden Kanal (30) innerhalb der ersten Chalkogenidglasschicht, wobei der leitende Kanal das Metallchalkogenidmaterial umfaßt.

22. Speichereinheit gemäß Anspruch 21, weiter umfassend eine leitfähige Strekke (32), verknüpft mit dem leitenden Kanal (30), wobei die leitende Strecke bereitgestellt wird, wenn die Speichereinheit auf einen ersten Speicherzustand programmiert ist.

23. Speichereinheit gemäß Anspruch 17, weiter umfassend eine dritte Chalkogenidglasschicht (18b) zwischen der Metallschicht und der zweiten Elektrode.

24. Speichereinheit gemäß Anspruch 17, wobei die Speichereinheit Teil eines Prozessorensystems (400) ist.

25. Speichereinheit gemäß Anspruch 17, weiter umfassend:
ein Substrat (10), wobei die erste Elektrode über dem Substrat ist, und
eine dritte Chalkogenidglasschicht (18b) über der Metallschicht, wobei die dritte Chalkogenidglasschicht Germaniumselenid umfaßt, und wobei:
die erste Chalkogenidglasschicht von Germaniumtelluridglas über der ersten Elektrode ist,
die Metallchalkogenidschicht über der ersten Chalkogenidglasschicht ist,
die zweite Chalkogenidglasschicht über der Metallchalkogenidschicht ist und Germaniumselenid umfaßt,
wobei die Metallschicht über der zweiten Chalkogenidglasschicht ist, und die Metallschicht Silber umfaßt, und die zweite Elektrode über der dritten Chalkogenidglasschicht ist.

26. Speichereinheit gemäß Anspruch 25, wobei das Germaniumtelluridglas eine stöchiometrische Formel GeₓTe₁₀₀₋ₓ aufweist, wobei x etwa 44 bis etwa 53 ist.

27. Speichereinheit gemäß Anspruch 25, wobei das Germaniumtelluridglas eine stöchiometrische Formel GeₓTe₁₀₀₋ₓ aufweist, wobei x etwa 46 bis etwa 51 ist.

28. Speichereinheit gemäß Anspruch 25, wobei das Germaniumtelluridglas eine stöchiometrische Formel GeₓTe₁₀₀₋ₓ aufweist, wobei x etwa 47 ist.

29. Speichereinheit gemäß Anspruch 25, weiter umfassend einen leitfähigen Kanal innerhalb der ersten Chalkogenidglasschicht, wobei der leitfähige Kanal das Metallchalkogenidmaterial umfaßt.

30. Speichereinheit gemäß Anspruch 29, weiter umfassend eine leitfähige Strekke, verknüpft mit dem leitfähigen Kanal, wobei die leitfähige Strecke bereitgestellt wird, wenn die Speichereinheit auf einen ersten Speicherzustand programmiert ist.

31. Speichereinheit gemäß Anspruch 25, wobei die zweite und dritte Chalkogenidglasschicht Ge₂Se₃ umfassen.

32. Speichereinheit gemäß Anspruch 25, wobei die Schichten, welche die Einheit aufbauen, vertikal gestapelt sind.

33. Speichereinheit gemäß Anspruch 25, wobei die Schichten, welche die Einheit aufbauen, in Kontakt miteinander sind.

34. PCRAM-Speicherzelle, umfassend die Einheit gemäß Anspruch 25, wobei:
die erste und zweite Elektrode Wolfram-Elektroden sind,
das Germaniumtelluridglas eine stoichiometrische Formel GeₓTe₁₀₀₋ₓ aufweist,
wobei x zwischen etwa 44 und etwa 53 ist, und ein leitfähiger Kanal in der ersten Chalkogenidglasschicht vorliegt.

35. Prozessorsystem, umfassend:
einen Prozessor und eine Speichereinheit, wobei die Speichereinheit wie in einem der Ansprüche 17 bis 23 definiert ist.

## Revendications

1. Procédé destiné à former un dispositif de mémoire (101), comprenant les étapes suivantes :
prévoir une première électrode (16) et une seconde électrode (24);
prévoir une couche de chalcogénure métallique (20) entre lesdites première et seconde électrodes, ladite couche de chalcogénure métallique comprenant du séléniure d'étain;
prévoir une première couche de verre de chalcogénure (18), constituée de verre de tellurure de germanium, entre lesdites première et seconde électrodes et en contact avec ladite couche de chalcogénure métallique;
prévoir une couche métallique (22) entre ladite couche de chalcogénure métallique et ladite seconde électrode; et
prévoir une seconde couche de verre de chalcogénure (18a) entre ladite couche de chalcogénure métallique et ladite couche métallique.

2. Procédé selon la revendication 1, dans lequel ladite couche de chalcogénure métallique est prévue entre ladite première couche de verre de chalcogénure et ladite seconde électrode.

3. Procédé selon la revendication 1, dans lequel ladite couche métallique comprend de l'argent.

4. Procédé selon la revendication 1, consistant, en outre, à prévoir une troisième couche de verre de chalcogénure (18b) entre ladite couche métallique et ladite seconde électrode.

5. Procédé selon la revendication 1, dans lequel ledit verre de tellurure de germanium a une formule stoéchiométrique GexTe100-x, où x a une valeur comprise entre environ 44 et 53.

6. Procédé selon la revendication 1, dans lequel ledit verre de tellurure de germanium a une formule stoéchiométrique GexTe100-x, où x a une valeur comprise entre environ 46 et 51.

7. Procédé selon la revendication 1, dans lequel ledit verre de tellurure de germanium a une formule stoéchiométrique GexTe100-x, où x a une valeur d'environ 47.

8. Procédé selon la revendication 1, comprenant, en outre, les étapes suivantes :
former la première électrode par dessus un substrat;
former la couche métallique par dessus la seconde couche de verre de chalcogénure; et
former une couche d'adhésion (18b) sur la couche métallique,
ladite couche métallique comprenant de l'argent.

9. Procédé selon la revendication 8, dans lequel ledit verre de tellurure de germanium a une formule stoéchiométrique GexTe100-x, où x a une valeur comprise entre environ 44 et 53.

10. Procédé selon la revendication 8, dans lequel ledit verre de tellurure de germanium a une formule stoéchiométrique GexTe100-x, où x a une valeur comprise entre environ 46 et 51.

11. Procédé selon la revendication 8, dans lequel ledit verre de tellurure de germanium a une formule stoéchiométrique GexTe100-x, où x a une valeur d'environ 47.

12. Procédé selon la revendication 8, dans lequel ladite première couche de verre de chalcogénure est en contact avec ladite première électrode.

13. Procédé selon la revendication 8, dans lequel les différentes couches de ladite cellule mémoire sont agencées verticalement.

14. Procédé selon la revendication 8, dans lequel ladite seconde couche de verre de chalcogénure est formée de Ge2Se3.

15. Procédé selon la revendication 8, dans lequel ladite couche d'adhésion est formée de Ge2Se3.

16. Procédé selon la revendication 8, dans lequel
les première et seconde électrodes sont des électrodes de tungstène;
ledit verre de tellurure de germanium a une formule stoéchiométrique GexTe100-x, la valeur x étant comprise entre environ 44 et 53;
la seconde couche de verre de chalcogénure comprend du séléniure de germanium et est formée par dessus ladite couche de chalcogénure métallique comprenant du séléniure d'étain;
la couche d'adhésion comprend du séléniure de germanium; et
ledit procédé consistant, en outre, à former un canal conducteur dans ladite première couche de verre de chalcogénure.

17. Dispositif de mémoire (101) comprenant :
une première électrode (16);
une seconde électrode (24);
un élément mémoire entre lesdites première et seconde électrodes, ledit élément mémoire comprenant une première couche de verre de chalcogénure (18) constituée de verre de tellurure de germanium et une couche de chalcogénure métallique (20) entre ladite première couche de verre de chalcogénure et ladite seconde électrode, ladite couche de chalcogénure métallique comprenant du séléniure d'étain;
une couche métallique (22) entre ladite couche de chalcogénure métallique et ladite seconde électrode; et
une seconde couche de verre de chalcogénure (18a) entre ladite couche de chalcogénure métallique et ladite couche métallique.

18. Dispositif de mémoire selon la revendication 17, dans lequel ledit verre de tellurure de germanium a une formule stoéchiométrique GexTe100-x, où x a une valeur comprise entre environ 44 et 53.

19. Dispositif de mémoire selon la revendication 17, dans lequel ledit verre de tellurure de germanium a une formule stoéchiométrique GexTe100-x, où x a une valeur comprise environ 46 et 51.

20. Dispositif de mémoire selon la revendication 17, dans lequel ledit verre de tellurure de germanium a une formule stoéchiométrique GexTe100-x, où x a une valeur d'environ 47.

21. Dispositif de mémoire selon la revendication 17, comprenant, en outre, un canal conducteur (30) à l'intérieur de ladite première couche de verre de chalcogénure, ledit canal conducteur comprenant ledit matériau de chalcogénure métallique.

22. Dispositif de mémoire selon la revendication 21, comprenant, en outre, un chemin conducteur (32) associé audit canal conducteur (30), ledit chemin conducteur étant prévu lorsque ledit dispositif de mémoire est programmé sur un premier état de mémoire.

23. Dispositif de mémoire selon la revendication 17, comprenant, en outre, une troisième couche de verre de chalcogénure (18b) entre ladite couche métallique et ladite seconde électrode.

24. Dispositif de mémoire selon la revendication 17, dans lequel ledit dispositif de mémoire fait partie d'un système processeur (400).

25. Dispositif de mémoire selon la revendication 17, comprenant, en outre :
un substrat (10) dans lequel la première électrode est par dessus le substrat; et
une troisième couche de verre de chalcogénure (18b) par dessus la couche métallique, la troisième couche de verre de chalcogénure comprenant du séléniure de germanium,
et dans lequel :
la première couche de verre de chalcogénure constituée de verre de tellurure de germanium est par dessus ladite première électrode;
la couche de chalcogénure métallique est par dessus ladite première couche de verre de chalcogénure;
la seconde couche de verre de chalcogénure est par dessus ladite couche de chalcogénure métallique, et comprend du séléniure de germanium;
la couche métallique est par dessus ladite seconde couche de verre de chalcogénure, et la couche métallique comprend de l'argent; et
la seconde électrode est par dessus ladite troisième couche de verre de chalcogénure.

26. Dispositif de mémoire selon la revendication 25, dans lequel ledit verre de tellurure de germanium a une formule stoéchiométrique GexTe100-x, où x a une valeur comprise entre environ 44 et 53.

27. Dispositif de mémoire selon la revendication 25, dans lequel ledit verre de tellurure de germanium a une formule stoéchiométrique GexTe100-x, où x a une valeur comprise entre environ 46 et 51.

28. Dispositif de mémoire selon la revendication 25, dans lequel 1 ledit verre de tellurure de germanium a une formule stoéchiométrique GexTe100-x, où x a une valeur d'environ 47.

29. Dispositif de mémoire selon la revendication 25, comprenant, en outre, un canal conducteur à l'intérieur de ladite première couche de verre de chalcogénure, ledit canal conducteur comprenant ledit matériau de chalcogénure métallique.

30. Dispositif de mémoire selon la revendication 29, comprenant, en outre, un chemin conducteur associé audit canal conducteur, ledit chemin conducteur étant prévu lorsque ledit dispositif de mémoire est programmé sur un premier état de mémoire.

31. Dispositif de mémoire selon la revendication 25, dans lequel lesdites seconde et troisième couches de verre de chalcogénure comprennent du Ge2Se3.

32. Dispositif de mémoire selon la revendication 25, dans lequel lesdites couches constituant ledit dispositif sont empilées verticalement.

33. Dispositif de mémoire selon la revendication 25, dans lequel lesdites couches constituant ledit dispositif sont en contact les unes avec les autres.

34. Cellule mémoire PCRAM, comprenant le dispositif selon la revendication 25 dans lequel :
les première et seconde électrodes sont des électrodes de tungstène;
ledit verre de tellurure de germanium a une formule stoéchiométrique GeₓTe₁₀₀₋ₓ, x ayant une valeur comprise entre environ 44 et 53; et
un canal conducteur est prévu dans ladite première couche de verre de chalcogénure.

35. Système processeur, comprenant :
un processeur et un dispositif de mémoire; ledit dispositif de mémoire étant tel que défini dans l'une quelconque des revendications 17 à 23.
